# EUROPEAN PATENT SPECIFICATION

(11) **EP 3 041 056 B1**
(45) Date of publication and mention of the grant of the patent: **24.04.2019**
(21) Application number: 15202365.1
(22) Date of filing: 23.12.2015
(51) Int. Cl.: H01L 35/14, H01L 35/32, H01L 37/02

(54) **THERMOELECTRIC GENERATOR**
THERMOELEKTRISCHER GENERATOR
GENERATEUR THERMOELECTRIQUE

(30) Priority: 05.01.2015 US 201514589553
(43) Date of publication of application: 06.07.2016
(73) Proprietor: The Boeing Company, Chicago, IL 60606-1596 (US)
(72) Inventor: SMITH, Shawn M., Chicago, IL 60606-2016 (US); DARMSTADT, Patrick R., Chicago, IL 60606-2016 (US)
(74) Representative: Boult Wade Tennant LLP

(56) References cited:
- JP-A- 2004 311 819
- JP-A- 2006 319 119
- US-A1- 2003 209 014
- US-A1- 2008 135 081
- US-A1- 2011 120 516
- US-A1- 2014 083 477
- US-A1- 2014 261 605

## Description

### BACKGROUND

The disclosure relates generally to devices and systems for generating electrical power, and more particularly, to thermoelectric devices and methods for generating electrical power.

Thermoelectric generators (TEGs), also known as Seebeck generators, are devices that convert a temperature differential into electrical energy using a phenomenon called the Seebeck effect. The thermal gradient is applied across two faces of the TEG, and electrical power is generated based on the change in temperature across the TEG itself. Thermoelectric generators can be applied in a variety of applications.

At least some known thermoelectric generators are used in applications where the amount of available space for a power source is limited and other known power sources may not be possible for use. Thermoelectric generators may also be used in applications, such as in a spacecraft, where it is desirable to have a reliable and durable power source that will operate continuously with little to no maintenance.

At least some known TEGs include a plurality of pairs of positive-type (p-type) and negative-type (n-type) semiconductors that are coupled in series by a plurality of conductive plates that are each soldered to a single p-type semiconductor to a single n-type semiconductor. The current state of TEG technology unwearyingly endures excessive manufacturing times and costs associated with individual installation of each p-type and n-type semiconductor, especially for large scale applications. Furthermore, the thickness of the TEG is limited due to macroscopic size of the p-type and n-type semiconductors that require human interfacing for installation. Moreover, at least some known TEGs include cube-shaped semiconductors that limit the shape of the resulting TEG to being substantially flat. Another drawback of at least some known TEGs is that the soldered connections between the semiconductors and the coupling plates have a temperature limit at which the solder will melt if exceeded. Finally, at least some conventional TEGs have a limited redundancy due to the semiconductors being connected in series to one another. Therefore, if one of the semiconductors becomes non-functioning, then the overall power output of the TEG may be significantly affected. Redundancy can be improved by coupling the semiconductors in parallel, but a large assembly including an increased amount of heavy wiring is required for such a configuration.

Thus there exists a need for a thermoelectric generator that is simpler to fabricate and, therefore, reduces manufacturing time and costs and also facilitates forming curved or other irregularly-shaped generators to conform to a surface of a support structure. Furthermore, there exists a need for a thermoelectric generator that may be used in nanoscale applications.

US 2008/0135081 A1 provides thermally insulated structure comprising a first surface and a second surface. The second surface is disposed in a spaced apart relationship with the first surface to define a gap, within which a layer of thermal insulation is provided. The thermal insulation includes a thermoelectric material.

JP 2006-319119 A aims to provide a technology which lessens time and effort of its manufacture by forming a thermoelectric module by the single conductive thermoelectric material. The provided thermoelectric module has the thermoelectric material inserted among the electrodes. Here, the case is shown where the thermoelectric module is a p-type. The thermoelectric module also has a lead line, and the electrodes are connected to the positive electrode and cathode of a power supply, respectively. The electrodes are not connected over the distinctly conductively thermoelectric material. Therefore, it is not necessary to connect many p-type and n-type chips of the thermoelectric material to the electrode connected to these. Consequently, the time and effort of formation are lessened. Moreover, there is also little concern of a connection failure. Moreover, the profile and flexibility of a design about a size are large.

US 2011/0120516 A1 describes a thermoelectric composite material containing electrically conductive polymeric fibrils in a polymer matrix with a high thermoelectric coefficient. There is also described a thermoelectric device using the composite. There is also described a thermoelectric device containing a thermoelectric layers and a thermoelectric device in which a thermal barrier isolates a thermoelectric layer from a structurally supporting substrate. The thermoelectric devices can be used to generate electricity or to control temperature.

JP 2004311819 discloses a thermoelectric module comprising a pair of heat transfer plates opposed to each other with a plurality of thermoelectric conversion materials extending between the heat transfer plates.

### BRIEF DESCRIPTION

In one aspect, a thermoelectric generator for powering a load is provided. The thermoelectric generator includes a first mounting plate, a second mounting plate, and a plurality of semiconductors positioned between the first and the second mounting plates to form a semiconductor layer. The semiconductors have a powdered granular structure. The semiconductor layer includes one of positive-type or negative-type semiconductors.

In another aspect, a method of assembling a thermoelectric generator is provided. The method includes applying a plurality of semiconductors to a first mounting plate to form a semiconductor layer. The semiconductors have a powdered granular structure. The semiconductor layer includes one of positive-type or negative-type semiconductors. A second mounting plate is positioned such that the semiconductor layer is positioned between the first and second mounting plates. The method also includes coupling the first mounting plate to the second mounting plate.

### BRIEF DESCRIPTION OF THE DRAWINGS

FIG. 1 is a cross-sectional view of an exemplary thermoelectric generator system including an exemplary thermoelectric generator;
FIG. 2 is a cross-sectional view of an alternative thermoelectric generator system;
FIG. 3 is a cross-sectional view of another alternative thermoelectric generator system;
FIG. 4 is a cross-sectional view of yet another alternative thermoelectric generator system;
FIG. 5 is a cross-sectional view of another alternative thermoelectric generator system; and
FIG. 6 is a flow diagram of a method of assembling the thermoelectric generator system shown in FIG. 1.
FIG. 7 is a flow diagram of a method of assembling the thermoelectric generator system shown in FIG. 5.

### DETAILED DESCRIPTION

Disclosed embodiments will now be described more fully hereinafter with reference to the accompanying drawings, in which some, but not all of the disclosed embodiments are shown. Indeed, several different embodiments may be provided and should not be construed as limited to the embodiments set forth herein. Rather, these embodiments are provided so that this disclosure will be thorough and complete and will fully convey the scope of the disclosure to those skilled in the art.

The disclosure provides for embodiments of a thermoelectric sandwich structure having a plurality of semiconductors that are only of a single type, either positive-type or negative-type. Embodiments of the structure and method may be used in aircraft, spacecraft, motorcraft, watercraft, and other craft, as well vehicles and structures. The thermoelectric generator disclosed herein reduces manufacturing times and costs as compared to known methods. Furthermore, because the semiconductors are applied to the mounting plates as a powder, the thermoelectric generators described herein may be used more readily in applications where the support structure is irregularly shaped, such as curved, or includes irregular features, such as projections or depressions.

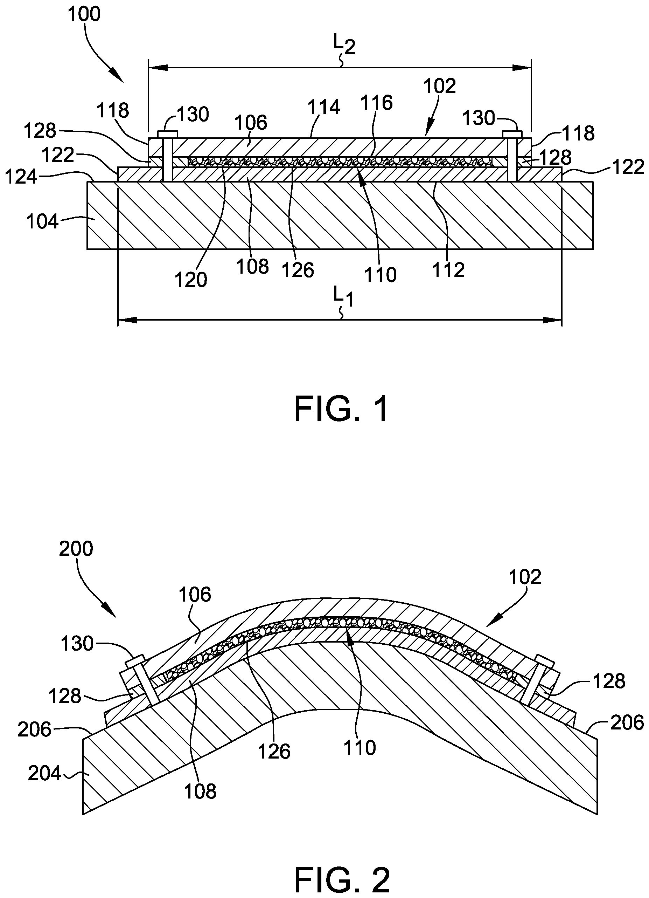

FIG. 1 is a cross-sectional view of an exemplary thermoelectric generator system 100 that includes an exemplary thermoelectric generator (TEG) 102 and a support structure 104 coupled thereto. TEG 102 includes a first mounting plate 106, a second mounting plate 108, and a semiconductor layer 110 positioned between plates 106 and 108. In the exemplary implementation, TEG 102 is configured to generate an electrical power based on a temperature differential between a bottom surface 112 of second mounting plate 108, which is coupled to support structure 104, and a top surface 114 of first mounting plate 106. TEG 102 then transfers the electrical power to a load (not shown), such as a battery or electrical device, for storage and/or consumption.

In the exemplary implementation, first mounting plate 106 includes top surface 114, a bottom surface 116, and opposing side edges 118. Similarly, second mounting plate 108 includes bottom surface 112, a top surface 120, and opposing side edges 122. Furthermore, second mounting plate 108 includes a length L1 that is longer than a length L2 of first mounting plate 106 to enable second mounting plate 108 to be coupled to an outer surface 124 of support structure 104. In the exemplary implementation, mounting plates 106 and 108 are formed from an electrically conductive material. For example, plates 106 and 108 are made from a metal or metal alloy such as, but not limited to, copper, aluminum, steel, or any combination thereof. Alternatively, mounting plates are made from any material that facilitates operation of TEG system 100 as described herein. Moreover, mounting plates 106 and 108 are flexible such that should support structure 104 bend and/or flex, mounting plates 106 and 108 are able to bend and/or flex to conform to the shape of support structure 104.

In the exemplary implementation, semiconductor layer 110 includes a plurality of semiconductors 126 that are each coupled to mounting plates 106 and 108. In the exemplary implementation, the plurality of semiconductors 126 are only one of either a positive type (p-type) semiconductor or negative type (n-type) semiconductor such that semiconductor layer 110 includes only a single type of semiconductor 126. As such, each semiconductor 126 is coupled in parallel to mounting plates 106 and 108. Coupling semiconductors 126 in parallel improves the redundancy of TEG 102 and, in the event a temperature limit of semiconductors 126 is exceeded at any point on a mounting plate 106 and 108, then only semiconductors 126 located at the point of the temperature spike are affected.

In the exemplary implementation, semiconductor layer 110 is made up of powdered granular semiconductors 126. Because TEG 102 includes only a single p-type or n-type, there is no requirement to manually solder pairs of p-type and n-type semiconductors together, and so any size limitations imparted on the semiconductors to enable soldering are removed. Alternatively, semiconductors 126 may be any size or shape, such as, but not limited to, cube-shaped that facilitates operation of TEG system 100 as described herein. Furthermore, one semiconductor 126 may be a different size than another semiconductor 126. Since semiconductors 126 are not coupled to each other, there is no requirement that each semiconductor 126 conform to the exact same size as another semiconductor 126. Semiconductor layer 110 made from powdered granular semiconductors 126 enables TEG 102 to be used in nano-scale applications where TEG 102 includes a thickness as small as a fraction of a nanometer where a decreased thickness of TEG 102 enables use of TEG 102 in applications where the available space for TEG 102 is limited. Alternatively, for large-scale production, such as, but not limited to, use on an aircraft component, semiconductor layer 110 may be multiple inches in thickness. More specifically, semiconductors 126 each include a diameter within a range of between approximately 10⁻⁹ nanometers and 30cm (1.0 foot). More specifically, a small-scale application of TEG 102 includes semiconductors 126 having a diameter within a range of between approximately 10⁻³ nanometers and approximately 10.0 nanometers. A mid-size scale application of TEG 102 includes semiconductors 126 having a diameter within a range of between approximately 0.001 millimeters and approximately 4.0 millimeters. A large-scale application of TEG 102 includes semiconductors 126 having a diameter within a range of between approximately 2.54mm (0.1 inch) and approximately 63.5mm (2.5 inches). Generally, because semiconductor layer 110 includes the plurality of granular semiconductors 126 and the thickness of layer 110 is not limited by the size of semiconductors 126, the thickness of TEG 102 is optimized based on the application.

TEG 102 further includes an insulation material 128 coupled between mounting plates 106 and 108. More specifically, insulation material 128 is coupled to at least one of bottom surface 116 of first mounting plate 106 and top surface 120 of second mounting plate 108 proximate side edges 118 and 122. In the exemplary implementation, insulation material 128 is configured to border semiconductor layer 110 such that first mounting plate 106 is prevented from directly contacting second mounting plate 108. Insulation material 128 is made from a non-conductive material, such as, but not limited to, rubber or plastic such that mounting plates 106 and 108 are electrically isolated from each other.

In the exemplary implementation, TEG 102 also includes a plurality of fasteners 130 that is configured to couple first mounting plate 106 to second mounting plate 108. More specifically, as shown in FIG. 1, fasteners 130 extend through mounting plates 106 and 108 proximate side edges 118 and 122 such that fasteners 130 extend through insulation material 128. Alternatively, fasteners 130 may extend through semiconductor layer 110. Fasteners 130 are made from a non-conductive material, such as, but not limited to, rubber or plastic such that mounting plates 106 and 108 are electrically isolated. Alternatively, fasteners 130 are made from a conductive material that includes a non-conductive insulator or sheath. In the exemplary implementation, fasteners 130 are configured to apply pressure to semiconductor layer 110 and insulation material 128 to trap semiconductors 126 between plates 106 and 108 to ensure a strong electrical coupling between plates 106 and 108 through semiconductors 126 in layer 110.

FIG. 2 is a cross-sectional view of an alternative thermoelectric generator system 200. TEG system 200 is substantially similar to TEG system 100 (shown in FIG. 1) with the exception that TEG system 100 includes a substantially flat support structure 104 and TEG system 200 includes a support structure 204 having an irregular shape. As such, elements common to both TEG systems 100 and 200 are labeled with like reference numerals as used in FIG. 1.

As shown in FIG. 2, support structure 204 includes at least one radius of curvature such that a surface 206 of support structure 204 is curved. Surface 206 defines a curved path to which TEG 102 is conformed such that TEG 102 is curved based on the radius of curvature of support structure 204. Although shown in FIG. 2 as being curved, TEG 102 conforms to any irregular shape of support structure 204. For example, TEG 102 conforms to support structure 204 having any combination of angular transitions, corners, openings, bulges, depressions, or any other irregularities. In the exemplary implementation, the powdered granular structure of semiconductors 126 facilitates enabling TEG 102 to have an irregular shape, that is, a shape that is not substantially smooth and planar. In one implementation, support structure 204 is an aircraft component, such as, but not limited to, an aircraft wing, that not only includes at least one radius of curvature, but also bends and flexes during flight of the aircraft. As described above, mounting plates 106 and 108 are also flexible to conform to the curvature and flexure of support structure 204. Furthermore, the powdered granular structure of semiconductors 126 facilitates a curved and/or flexible semiconductor layer 110 that conforms to the curvature and flexure of mounting plates 106 and 108 and support structure 204.

Furthermore, although FIGs. 1 and 2 show only a single layer of semiconductors 126 in TEG 102 mounted to support structure 104 or 204, it is contemplated that multiple layers of semiconductors 126 may be included in TEG 102. More specifically, a TEG 102 stack-up may include, in series, mounting plate 108, semiconductor layer 110, an intermediate mounting plate (not shown), another semiconductor layer 110, and mounting plate 106. A TEG 102 stack-up may include any number of semiconductor layers 110 and intermediate mounting plates. Moreover, in such a stack of TEG 102, a first semiconductor layer 110 may include p-type semiconductors 126 and a second semiconductor layer 110 in the stack may include n-type semiconductors. Alternatively, all semiconductor layers 110 of the stack may include p-type or n-type semiconductors.

Additionally, with respect to FIGs. 1 and 2, although mounting plate 108 and support structures 104 and 204, respectively, are shown as separate components, in one implementation, support structures 104 and 204 double in function as mounting plate 108 such that mounting plate 108 and support structures 104 and 204 are integral and conductive adhesive is applied directly to support structures 104 and 204.

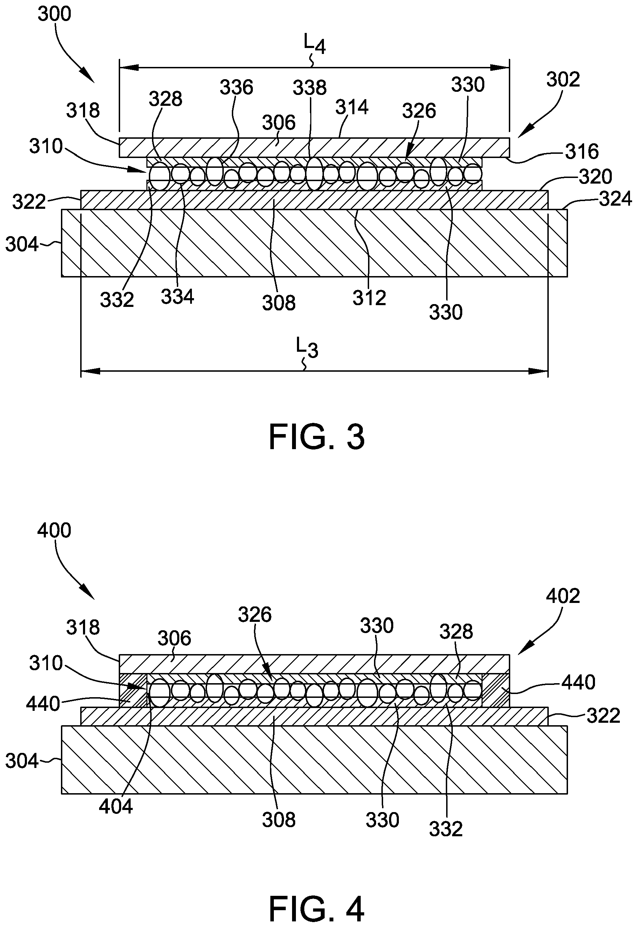

FIG. 3 is a cross-sectional view of another alternative thermoelectric generator system 300 that includes an alternative thermoelectric generator 302 and a support structure 304 coupled thereto. Similar to TEG 102, TEG 302 includes a first mounting plate 306, a second mounting plate 308, and a semiconductor layer 310 positioned between plates 306 and 308. TEG 302 is also configured to generate an electrical power based on a temperature differential between a bottom surface 312 of second mounting plate 308, which is coupled to support structure 304, and a top surface 314 of first mounting plate 306. TEG 302 then transfers the electrical power to a load (not shown), such as a battery or electrical device, for storage and/or consumption.

In one implementation, first mounting plate 306 includes top surface 314, a bottom surface 316, and opposing side edges 318. Similarly, second mounting plate 308 includes bottom surface 312, a top surface 320, and opposing side edges 322. Furthermore, second mounting plate 308 includes a length L3 that is longer than a length L4 of first mounting plate 306 to enable second mounting plate 308 to be coupled to an outer surface 324 of support structure 304. As in TEG system 100, mounting plates 306 and 308 of TEG system 300 are formed from an electrically conductive material and are flexible such that should support structure 304 bend and/or flex, mounting plates 306 and 308 are able to bend and/or flex to conform to the shape of support structure 304. Alternatively, mounting plates 306 and 308 are substantially similar in length. Generally, mounting plates 306 and 308 have any length that enables operation of TEG system 300 as described herein.

TEG 302 includes semiconductor layer 310 having a plurality of semiconductors 326 that are each electrically coupled to mounting plates 306 and 308, as described in further detail below. Similar to semiconductors 126 of TEG 102, the plurality of semiconductors 326 of TEG 302 are only one of either a positive type (p-type) semiconductor or negative type (n-type) semiconductor such that semiconductor layer 310 includes only a single type of semiconductor 326. As such, each semiconductor 326 is electrically coupled in parallel to mounting plates 306 and 308. Semiconductor layer 310 is also made up of a plurality of powdered granular semiconductors 326 that are of a single p-type or n-type and are not individually soldered together. Semiconductors 326 are substantially similar to semiconductors 126 such that the description and benefits discussed above with respect to semiconductors 126 also apply to semiconductors 326.

TEG 302 further includes a first layer 328 of a conductive adhesive 330 and a second layer 332 of conductive adhesive 330. More specifically, TEG 302 includes first layer 328 of conductive adhesive 330 applied to bottom surface 316 of first mounting plate 306 and second layer 332 of conductive adhesive 330 applied to top surface 320 of second mounting plate 308. In one implementation, conductive adhesive 330 is an electrically conductive paint applied to at least one of mounting plate 306 and 308 using a brush or a spray. Alternatively, conductive adhesive 330 is an electrically conductive material, such as, but not limited to, a paint, an epoxy, a sealant, a low temperature melting metal, such as lead, and a bonding agent mixed with silver, nickel, or graphite, that is applied to mounting plates 306 and 308 in any manner.

The conductive qualities of conductive adhesive 330 couples semiconductors 326 in electrical communication with mounting plates 306 and 308, while the adhesive qualities of adhesive 330 mechanically couples mounting plate 306 to mounting plate 308 without requiring a fastener. Alternatively, a fastener, such as fastener 130 (shown in FIG. 1) is used to mechanically couple mounting plates 306 and 308 to each other. Conductive adhesive 330 provides TEG 302 with a surface to which semiconductors 326 can adhere and be fixed in place. As shown in FIG. 3, semiconductors 326 may be different sizes such that a first semiconductor 334 is coupled between adhesive layers 328 and 332 and does not contact either of plates 306 or 308, while a second semiconductor 336 contacts only one of plates 306 or 308 and an opposing adhesive layer 332 or 328, respectively. A third semiconductor 338 is of such a size that semiconductor 338 extends through both layers 328 and 332 and contacts both plates 306 and 308. Sizes of semiconductors 326 and thicknesses of layers 310, 328, and 332 are shown in FIG. 3 for illustrative purposes only and may not be representative of actual sizes and thicknesses. For example, semiconductor layer 310 may include a greater number of semiconductors 326 than are shown in FIG. 3.

TEG 302 may also include an insulation material (not shown) that is similar in composition and function to insulation material 128 (shown in FIG. 1). The insulation material is coupled to plates 306 and 308 and defines a thickness that prevents contact between conductive adhesive 330 of layers 328 and 332. Alternatively, or in combination, semiconductor layer 310 defines a thickness that prevents contact between conductive adhesive 330 of layers 328 and 332. Generally, conductive adhesive layers 328 and 332 are prevented from contacting each other to reduce the occurrence of electricity passing between plates 306 and 308 via conductive adhesive 330 and bypassing semiconductors 326.

Furthermore, although FIG. 3 shows only a single layer of semiconductors 326 in TEG 302 mounted to support structure 304, it is contemplated that multiple layers of semiconductors 326 may be included in TEG 302. More specifically, a TEG 302 stack may include, in series, mounting plate 308, conductive adhesive 330, semiconductors 326, conductive adhesive 330, semiconductors 326, conductive adhesive 330, and mounting plate 306. A TEG 302 stack may include any number of semiconductor 326 and adhesive 330 layers. Moreover, in such a stack of TEGs 302, a first semiconductor layer 326 may include p-type semiconductors 326 and a second semiconductor layer 326 in the stack may include n-type semiconductors. Alternatively, all semiconductor layers 326 of the stack may include p-type or n-type semiconductors.

FIG. 4 is a cross-sectional view of an alternative thermoelectric generator system 400. TEG system 400 is substantially similar to TEG system 300 (shown in FIG. 3) with the exception that a TEG 402 of TEG system 400 includes a layer of a resistive adhesive 404 applied between layers 328 and 332 of conductive adhesive 330. As such, elements common to both TEG systems 300 and 400 are labeled with like reference numerals in FIG. 4 as those used in FIG. 3. In one implementation, resistive adhesive 404 is made from a non-conductive material, such as, but not limited to, rubber or plastic such that layers 328 and 332 of conductive adhesive 330 are electrically isolated from each other. Similar to conductive adhesive 330, in one application, resistive adhesive 404 may be applied using a brush or by spraying adhesive 404 onto at least one of conductive adhesive layers 328 and 332. Furthermore, semiconductors 326 may be mixed with resistive adhesive 404 and applied to layers 328 and 332. Alternatively, in one implementation, TEG 402 does not include conductive adhesive layers 328 and 332 and semiconductors 326 may be mixed with resistive adhesive 404 and applied directly to mounting plates 306 and 308. As described above with respect to FIG. 3, the sizes of semiconductors 326 and thicknesses of layers 310, 328, 332, and 404 are shown in FIG. 4 for illustrative purposes only and may not be representative of actual sizes and thicknesses.

TEG 402 may also include an insulation material 440 that is similar in composition and function to insulation material 128 (shown in FIG. 1). Insulation material 440 is coupled to plates 306 and 308 proximate side edges 318 and 322, respectively, and defines a thickness that prevents contact between conductive plates 306 and 308.

Furthermore, although FIG. 4 shows only a single layer of semiconductors 326 in TEG 402 mounted to support structure 304, it is contemplated that multiple layers of semiconductors 326 may be included in TEG 402. More specifically, a TEG 402 stack-up may include, in series, mounting plate 308, conductive adhesive 330, semiconductors 326, resistive adhesive 404, conductive adhesive 330, semiconductors 326, resistive adhesive 404, conductive adhesive 330, and mounting plate 306. A TEG 402 stack-up may include any number of semiconductor 326, resistive adhesive 404 and conductive adhesive 330 layers. Moreover, in such a stack-up of TEG 402, a first semiconductor layer 326 may include p-type semiconductors 326 and a second semiconductor layer 326 in the stack-up may include n-type semiconductors. Alternatively, all semiconductor layers 326 of the stack-up may include p-type or n-type semiconductors.

Additionally, with respect to FIGs. 3 and 4, although mounting plate 308 and support structure 304 are shown as separate components, in one implementation, support structure 304 doubles in function as mounting plate 308 such that mounting plate 308 and support structure 304 are integral and conductive adhesive is applied directly to support structure 304.

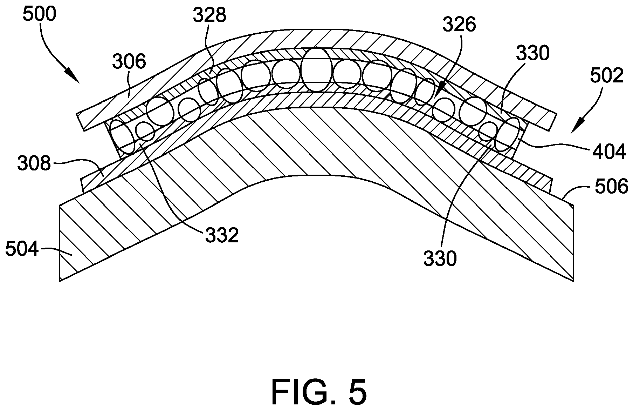

FIG. 5 is a cross-sectional view of an alternative thermoelectric generator system 500. TEG system 500 is substantially similar to TEG system 400 (shown in FIG. 4) with the exception that TEG system 400 includes a substantially flat support structure 304 and TEG system 500 includes a support structure 504 having an irregular shape. As such, elements common to both TEG systems 500 and 400 are labeled with like reference numerals as used in FIG. 4.

As shown in FIG. 5, support structure 504 includes at least one radius of curvature such that a surface 506 of support structure 504 is curved, similar to support structure 204 (shown in FIG. 2). Surface 506 defines a curved path to which TEG 502 is conformed such that TEG 402 is curved based on the radius of curvature of support structure 504. Although shown in FIG. 5 as being curved, TEG 502 conforms to any irregular shape of support structure 504. For example, TEG 502 conforms to support structure 504 having any combination of angular transitions, corners, openings, bulges, depressions, or any other irregularities. In the exemplary implementation, the powdered granular structure of semiconductors 326 facilitates enabling TEG 502 to have an irregular shape, that is, a shape that is not substantially smooth and planar. In one implementation, support structure 504 is an aircraft component, such as, but not limited to, an aircraft wing, that not only includes at least one radius of curvature, but also bends and flexes during flight of the aircraft. As described above, mounting plates 306 and 308 are also flexible to conform to the curvature and flexure of support structure 504. Furthermore, the powdered granular structure of semiconductors 326 facilitates a curved and/or flexible semiconductor layer 310 that conforms to the curvature and flexure of mounting plates 306 and 308 and support structure 504.

Furthermore, although FIG. 5 shows only a single layer of semiconductors 326 in TEG 502 mounted to support structure 504, it is contemplated that multiple layers of semiconductors 326 may be included in TEG 502. More specifically, a TEG 502 stack-up may include, in series, mounting plate 308, conductive adhesive 330, semiconductors 326, resistive adhesive 404, conductive adhesive 330, semiconductors 326, resistive adhesive 404, conductive adhesive 330, and mounting plate 306. A TEG 502 stack-up may include any number of semiconductor 326, resistive adhesive 404 and conductive adhesive 330 layers. Moreover, in such a stack of TEG 502, a first semiconductor layer 326 may include p-type semiconductors 326 and a second semiconductor layer 326 in the stack-up may include n-type semiconductors. Alternatively, all semiconductor layers 326 of the stack-up may include p-type or n-type semiconductors.

Additionally, although mounting plate 308 and support structure 504 are shown as separate components, in one implementation, support structure 504 doubles in function as mounting plate 308 such that mounting plate 308 and support structure are integral and conductive adhesive is applied directly to support structure 504.

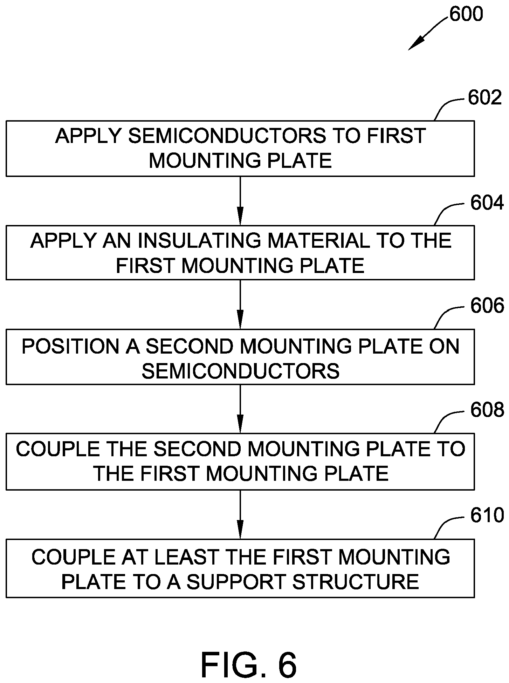

FIG. 6 is a flow diagram of a method 600 of assembling a TEG system, such as TEG system 100, which includes a TEG, such as TEG 102 (both shown in FIG. 1). Method 600 includes applying 602 a plurality of powdered granular semiconductors, such as semiconductors 126 (shown in FIG. 1), to a first mounting plate, such as mounting plate 108 (shown in FIG. 1), to form a semiconductor layer, such as semiconductor layer 110 (shown in FIG. 1). As described above, the semiconductor layer includes semiconductors that are one of positive-type or negative-type semiconductors such that the semiconductor layer includes semiconductors that are all the same type. Method 600 also includes applying 604 an insulating material, such as insulating material 128 (shown in FIG. 1) to at least one of the top surface, such as top surface 120 (shown in FIG. 1), of the first mounting plate and to a bottom surface, such as bottom surface 116 (shown in FIG. 1), of a second mounting plate, such as mounting plate 106 (shown in FIG. 1). More specifically, the insulation material is coupled proximate a first plurality of side edges, such as side edges 118 (shown in in FIG. 1), of the second mounting plate and proximate a second plurality of side edges, such as side edges 122 (shown in FIG. 1) of the first mounting plate.

Method 600 also includes positioning 606 the second mounting plate on top of the semiconductor layer such that the semiconductor layer is positioned between the first and second mounting plates. The first mounting plate is then coupled 608 to the second mounting plate to complete assembly of the TEG. In one embodiment, the coupling 608 step is performed using at least one of a non-conductive and an insulated fastener, such as fastener 130 (shown in FIG. 1). Once assembled, the TEG is then coupled 610 to a support structure, such as support structure 104 (shown in FIG. 1). Alternatively, the first mounting plate is coupled 610 to the support structure prior to assembly of the TEG. As described above, the support structure may be substantially smooth and planar, such as support structure 104 (shown in FIG. 1), or the support structure may include a radius of curvature or other irregular shape, such as support structure 204 (shown in FIG. 2).

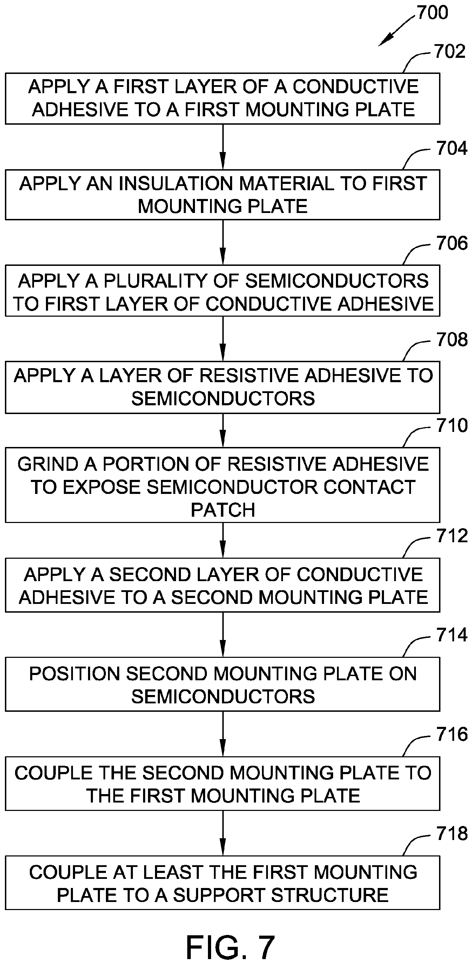

FIG. 7 is a flow diagram of a method 700 of assembling an alternative TEG system, such as TEG system 400, which includes a TEG, such as TEG 402 (both shown in FIG. 4). Method 700 includes applying 702 a first layer, such as layer 328, of a conductive adhesive, such as adhesive 330, to a predetermined region of a first mounting plate, such as mounting plate 308 (all shown in FIG. 4). An insulation material, such as insulation material 440 (shown in FIG. 4), is then applied 704 to the first mounting plate about a periphery of the conductive adhesive. Once the insulation material and conductive adhesives are at least partially set, a plurality of powdered granular semiconductors, such as semiconductors 326 (shown in FIG. 4), is applied 706 to the first layer of conductive adhesive to form a semiconductor layer, such as semiconductor layer 310 (shown in FIG. 4). As described above, the semiconductor layer includes semiconductors that are one of positive-type or negative-type semiconductors such that the semiconductor layer includes semiconductors that are all the same type.

Method 700 also includes applying 708 a layer of a resistive adhesive, such as resistive adhesive 404 (shown in FIG. 4), to the semiconductor layer and grinding 710 a portion of the resistive adhesive to expose at least a portion of the semiconductors. A second layer on the conductive adhesive, such as second layer 332 (shown in FIG. 4) is applied 712 to a predetermined region of a second mounting plate, such as mounting plate 306 (shown in FIG. 4). Method 700 also includes positioning 714 the second mounting plate on top of the first mounting plate such that the first and second conductive adhesive layers, the resistive adhesive layer, and the semiconductor layer are all sandwiched therebetween. The first mounting plate is then coupled 716 to the second mounting plate using the adhesives to complete assembly of the TEG. In one embodiment, the coupling 716 step is performed using at least one of a non-conductive and an insulated fastener, such as fastener 130 (shown in FIG. 1). Once assembled, the TEG is then coupled 718 to a support structure, such as support structure 304 (shown in FIG. 4). Alternatively, the first mounting plate is coupled 718 to the support structure prior to assembly of the TEG. As described above, the support structure may be substantially smooth and planar, such as support structure 304 (shown in FIG. 4), or the support structure may include a radius of curvature or other irregular shape, such as support structure 504 (shown in FIG. 5).

The implementations described herein describe improved thermoelectric generators that are used in a wide variety of applications. The thermoelectric generators described herein include a plurality of powdered granular semiconductors that are only of a single type. More specifically, all of the semiconductors are either positive-type or negative-type such that the thermo-electric generator includes only one type of semiconductor. The semiconductors are coupled in parallel electrical communication with upper and lower mounting plates using at least one of a mechanical fastener that presses the plates together and a conductive adhesive. As such, there is no requirement that the semiconductors be independently soldered to one another or to the mounting plates. The improved thermoelectric generator therefore significantly reduces manufacturing times and costs as compared to known methods. Furthermore, because the semiconductors are applied to the mounting plates as a powder, the thermoelectric generators described herein may be used in applications where the support structure is irregularly shaped, such as curved, or includes irregular features, such as projections or depressions.

## Claims

1. A thermoelectric generator (102) for powering a load, said thermo-electric generator (102) comprising:
a first mounting plate (106);
a second mounting plate (108); and
a plurality of semiconductors (126) positioned between said first and said second mounting plates (106, 108) to form a semiconductor layer (110), the plurality of semiconductors having a powdered granular structure, wherein said plurality of semiconductors are only one of either positive-type or negative-type semiconductors (126) such that the semiconductor layer includes only a single type of semiconductor, each of said plurality of semiconductors being electrically coupled in parallel to said first and second mounting plates.

2. The thermoelectric generator (102) of Claim 1, wherein each semiconductor includes a diameter within a range of between approximately 0.001 millimeters and approximately 4.0 millimeters.

3. The thermoelectric generator (102) of Claims 1 or 2, further comprising at least one mechanical fastener (130) configured to couple said first mounting plate (106) to said second mounting plate (108).

4. The thermoelectric generator (102) of any of Claims 1 to 3, wherein said first mounting plate (106) comprises a top surface (114) and a first plurality of side edges, and wherein said second mounting plate (108) comprises a bottom surface (112) and a second plurality of side edges, said thermoelectric generator (102) further comprising an insulating material applied to at least one of said top and said bottom surfaces (114, 112) proximate said first and said second pluralities of side edges.

5. The thermoelectric generator (102) of any of Claims 1 to 4, further comprising a conductive adhesive (330) applied to at least one of said first and said second mounting plates (106, 108).

6. The thermoelectric generator (102) of any of Claims 1 to 5, further comprising:
a first layer of a conductive adhesive (330) applied to said first mounting plate (106);
a second layer of said conductive adhesive (330) applied to said second mounting plate (108);
a layer of resistive material coupled between said first and said second layers of conductive adhesive (330).

7. The thermoelectric generator (102) of any of Claims 1 to 6, further comprising a support structure (104) coupled to said first mounting plate (106), wherein said support structure (104) comprises at least one radius of curvature such that said thermoelectric generator (102) is curved based on the radius of curvature.

8. The thermoelectric generator (102) of Claim 7, wherein said first mounting plate (106) is integral with said support structure (104).

9. A method of assembling a thermoelectric generator (102), said method comprising:
applying a plurality of semiconductors (126) to a first mounting plate (106) to form a semiconductor layer (110), the plurality of semiconductors having a powdered granular structure, wherein said plurality of semiconductors are only one of either positive-type or negative-type semiconductors (126) such that the semiconductor layer includes only a single type of semiconductor, each of said plurality of semiconductors being electrically coupled in parallel to said first and second mounting plates;
positioning a second mounting plate (108) such that the semiconductor layer (110) is positioned between the first and second mounting plates (106, 108); and
coupling the first mounting plate (106) to the second mounting plate (108).

10. The method of Claim 9, wherein applying a plurality of semiconductors (126) comprises applying a plurality semiconductors (126) that each include a diameter within a range of between approximately 0.001 millimeters and approximately 4.0 millimeters.

11. The method of Claim 9 or 10, wherein coupling the first mounting plate (106) to the second mounting plate (108) comprises coupling the first mounting plate (106) to the second mounting plate (108) using mechanical fastener (130).

12. The method of any of Claims 9 to 11, wherein the first mounting plate (106) includes a top surface (114) and a first plurality of side edges, and wherein the second mounting plate (108) includes a bottom surface (112) and a second plurality of side edges, said method further comprising applying an insulating material to at least one of the top and bottom surfaces (114, 112) proximate the first and second pluralities of side edges.

13. The method of any of Claims 9 to 12, further comprising applying a conductive adhesive (330) to at least one of the first and second mounting plates (106, 108).

14. The method of any of Claims 9 to 13, wherein applying a plurality of semiconductors (126) comprises applying a mixture of the plurality of semiconductors (126) and a non-conductive medium.

15. The method of any of Claims 9 to 14, further comprising:
applying a first layer of a conductive adhesive (330) to the first mounting plate (106);
applying a second layer of the conductive adhesive (330) to the second mounting plate (108); and
applying a layer of resistive material between the first and second layers of conductive adhesive (330).

## Patentansprüche

1. Thermoelektrischer Generator (102) zum Versorgen einer Last, wobei der thermoelektrische Generator (102) umfasst:
eine erste Montageplatte (106);
eine zweite Montageplatte (108); und
eine Mehrzahl von Halbleitern (126), die zwischen der ersten und der zweiten Montageplatte (106, 108) angeordnet sind, um eine Halbleiterschicht (110) zu bilden, wobei die Mehrzahl von Halbleitern eine pulverförmige Granulatstruktur aufweist, wobei die Mehrzahl von Halbleitern entweder nur vom positiven oder nur vom negativen Typ (126) ist, so dass die Halbleiterschicht nur einen einzigen Halbleitertyp aufweist, wobei jeder der Mehrzahl von Halbleitern elektrisch parallel an die erste und die zweite Montageplatte angeschlossen ist.

2. Thermoelektrischer Generator (102) nach Anspruch 1, bei dem jeder Halbleiter einen Durchmesser in einem Bereich zwischen etwa 0,001 Millimetern und etwa 4,0 Millimetern aufweist.

3. Thermoelektrischer Generator (102) nach Anspruch 1 oder 2, ferner mit mindestens einem mechanischen Befestigungselement (130), das konfiguriert ist, um die erste Montageplatte (106) mit der zweiten Montageplatte (108) zu verbinden.

4. Thermoelektrischer Generator (102) nach einem der Ansprüche 1 bis 3, bei dem die erste Montageplatte (106) eine Oberseite (114) und eine erste Mehrzahl von Seitenkanten aufweist, und bei dem die zweite Montageplatte (108) eine Unterseite (112) und eine zweite Mehrzahl von Seitenkanten aufweist, wobei der thermoelektrische Generator (102) ferner ein Isoliermaterial aufweist, das auf die Oberseite (114) und/oder die Unterseite (112) nahe der ersten und der zweiten Mehrzahl von Seitenkanten aufgebracht ist.

5. Thermoelektrischer Generator (102) nach einem der Ansprüche 1 bis 4, ferner mit einem leitfähigen Klebstoff (330), der auf die erste und/oder die zweite Montageplatte (106, 108) aufgebracht ist.

6. Thermoelektrischer Generator (102) nach einem der Ansprüche 1 bis 5, ferner mit:
einer ersten Schicht eines leitfähigen Klebstoffs (330), die an der ersten Montageplatte (106) angebracht ist;
einer zweiten Schicht des leitfähigen Klebstoffs (330), die an der zweiten Montageplatte (108) angebracht ist;
einer Schicht aus resistivem Material, die zwischen der ersten und der zweiten Schicht aus leitfähigem Klebstoff (330) angeschlossen ist.

7. Thermoelektrischer Generator (102) nach einem der Ansprüche 1 bis 6, ferner mit einer Trägerstruktur (104), die mit der ersten Montageplatte (106) verbunden ist, wobei die Trägerstruktur (104) mindestens einen Krümmungsradius der Art aufweist, dass der thermoelektrische Generator (102) basierend auf dem Krümmungsradius gekrümmt ist.

8. Thermoelektrischer Generator (102) nach Anspruch 7, wobei die erste Montageplatte (106) integral mit der Trägerstruktur (104) ausgebildet ist.

9. Verfahren zum Zusammenbauen eines thermoelektrischen Generators (102), wobei das Verfahren umfasst:
Aufbringen einer Mehrzahl von Halbleitern (126) auf eine erste Montageplatte (106), um eine Halbleiterschicht (110) zu bilden, wobei die Mehrzahl von Halbleitern eine pulverförmige körnige Struktur aufweist, wobei die Mehrzahl von Halbleitern Halbleiter entweder nur vom positiven oder nur vom negativen Typ (126) sind, so dass die Halbleiterschicht nur einen einzigen Halbleitertyp beinhaltet, wobei jeder der Mehrzahl von Halbleitern elektrisch parallel an die erste und die zweite Montageplatte angeschlossen ist;
Positionieren einer zweiten Montageplatte (108), so dass die Halbleiterschicht (110) zwischen der ersten und zweiten Montageplatte (106, 108) positioniert ist; und
Verbinden der ersten Montageplatte (106) mit der zweiten Montageplatte (108).

10. Verfahren nach Anspruch 9, worin das Aufbringen einer Mehrzahl von Halbleitern (126) das Aufbringen einer Mehrzahl von Halbleitern (126) mit jeweils einem Durchmesser in einem Bereich zwischen etwa 0,001 Millimetern und etwa 4,0 Millimetern umfasst.

11. Verfahren nach Anspruch 9 oder 10, bei dem das Verbinden der ersten Montageplatte (106) mit der zweiten Montageplatte (108) das Verbinden der ersten Montageplatte (106) mit der zweiten Montageplatte (108) unter Verwendung eines mechanischen Verbindungselements (130) umfasst.

12. Verfahren nach einem der Ansprüche 9 bis 11, bei dem die erste Montageplatte (106) eine Oberseite (114) und eine erste Mehrzahl von Seitenkanten aufweist, und bei dem die zweite Montageplatte (108) eine Unterseite (112) und eine zweite Mehrzahl von Seitenkanten aufweist, wobei das Verfahren ferner das Aufbringen eines Isoliermaterials auf die Oberseite (114) und/oder die Unterseite (112) nahe der ersten und zweiten Mehrzahl von Seitenkanten umfasst.

13. Verfahren nach einem der Ansprüche 9 bis 12, ferner mit dem Aufbringen eines leitfähigen Klebstoffs (330) auf die erste und/oder die zweite Montageplatte (106, 108).

14. Verfahren nach einem der Ansprüche 9 bis 13, bei dem das Aufbringen einer Mehrzahl von Halbleitern (126) das Aufbringen einer Mischung aus der Mehrzahl von Halbleitern (126) und einem nichtleitenden Medium umfasst.

15. Verfahren nach einem der Ansprüche 9 bis 14, ferner mit den Schritten:
Anbringen einer ersten Schicht eines leitfähigen Klebstoffs (330) an der ersten Montageplatte (106);
Anbringen einer zweiten Schicht des leitfähigen Klebstoffs (330) an der zweiten Montageplatte (108); und
Anbringen einer Schicht aus resistivem Material zwischen der ersten und der zweiten Schicht aus leitfähigem Klebstoff (330).

## Revendications

1. Générateur thermoélectrique (102) pour alimenter une charge, ledit générateur thermoélectrique (102) comprenant :
une première plaque de montage (106) ;
une seconde plaque de montage (108) ; et
une pluralité de semi-conducteurs (126) positionnés entre lesdites première et seconde plaques de montage (106, 108) pour former une couche semi-conductrice (110), la pluralité de semi-conducteurs ayant une structure granulaire en poudre, dans lequel ladite pluralité de semi-conducteurs ne sont que l'un de semi-conducteurs de type positif ou de type négatif (126), de telle sorte que la couche semi-conductrice ne comprend qu'un seul type de semi-conducteur, chacun de ladite pluralité de semi-conducteurs étant couplé électriquement en parallèle auxdites première et seconde plaques de montage.

2. Générateur thermoélectrique (102) selon la revendication 1, dans lequel chaque semi-conducteur a un diamètre compris dans une plage allant d'environ 0,001 millimètre à environ 4,0 millimètres.

3. Générateur thermoélectrique (102) selon les revendications 1 ou 2, comprenant en outre au moins une fixation mécanique (130) configurée pour coupler ladite première plaque de montage (106) à ladite seconde plaque de montage (108).

4. Générateur thermoélectrique (102) selon l'une quelconque des revendications 1 à 3, dans lequel ladite première plaque de montage (106) comprend une surface supérieure (114) et une première pluralité de bords latéraux, et dans lequel ladite seconde plaque de montage (108) comprend une surface inférieure (112) et une seconde pluralité de bords latéraux, ledit générateur thermoélectrique (102) comprenant en outre un matériau isolant appliqué sur au moins l'une desdites surfaces supérieure et inférieure (114, 112) à proximité desdites première et seconde pluralités de bords latéraux.

5. Générateur thermoélectrique (102) selon l'une quelconque des revendications 1 à 4, comprenant en outre un adhésif conducteur (330) appliqué sur au moins l'une desdites première et seconde plaques de montage (106, 108).

6. Générateur thermoélectrique (102) selon l'une quelconque des revendications 1 à 5, comprenant en outre :
une première couche d'un adhésif conducteur (330) appliqué à ladite première plaque de montage (106) ;
une seconde couche dudit adhésif conducteur (330) appliquée sur ladite seconde plaque de montage (108) ;
une couche de matériau résistif couplée entre lesdites première et seconde couches d'adhésif conducteur (330).

7. Générateur thermoélectrique (102) selon l'une quelconque des revendications 1 à 6, comprenant en outre une structure de support (104) couplée à ladite première plaque de montage (106), dans lequel ladite structure de support (104) comprend au moins un rayon de courbure tel que ledit générateur thermoélectrique (102) est courbé sur la base du rayon de courbure.

8. Générateur thermoélectrique (102) selon la revendication 7, dans lequel ladite première plaque de montage (106) est d'un seul tenant avec ladite structure de support (104).

9. Procédé d'assemblage d'un générateur thermoélectrique (102), ledit procédé comprenant les étapes consistant à :
appliquer une pluralité de semi-conducteurs (126) sur une première plaque de montage (106) pour former une couche semi-conductrice (110), la pluralité de semi-conducteurs ayant une structure granulaire en poudre, dans lequel ladite pluralité de semi-conducteurs ne sont que l'un de semi-conducteurs de type positif ou de type négatif (126), de telle sorte que la couche semi-conductrice ne comprend qu'un seul type de semi-conducteur, chacun de ladite pluralité de semi-conducteurs étant couplé électriquement en parallèle auxdites première et seconde plaques de montage ;
positionner une seconde plaque de montage (108) de telle sorte que la couche semi-conductrice (110) soit positionnée entre les première et seconde plaques de montage (106, 108) ; et
coupler la première plaque de montage (106) à la seconde plaque de montage (108).

10. Procédé selon la revendication 9, dans lequel l'application d'une pluralité de semi-conducteurs (126) comprend l'application d'une pluralité de semi-conducteurs (126) qui comprennent chacun un diamètre dans une plage allant d'environ 0,001 millimètre à environ 4,0 millimètres.

11. Procédé selon la revendication 9 ou 10, dans lequel le couplage de la première plaque de montage (106) à la seconde plaque de montage (108) comprend le couplage de la première plaque de montage (106) à la seconde plaque de montage (108) en utilisant une fixation mécanique (130).

12. Procédé selon l'une quelconque des revendications 9 à 11, dans lequel la première plaque de montage (106) comprend une surface supérieure (114) et une première pluralité de bords latéraux, et dans lequel la seconde plaque de montage (108) comprend une surface inférieure (112) et une seconde pluralité de bords latéraux, ledit procédé comprenant en outre l'application d'un matériau isolant sur au moins l'une des surfaces supérieure et inférieure (114, 112) à proximité des première et seconde pluralités de bords latéraux.

13. Procédé selon l'une quelconque des revendications 9 à 12, comprenant en outre l'application d'un adhésif conducteur (330) sur au moins l'une des première et seconde plaques de montage (106, 108).

14. Procédé selon l'une quelconque des revendications 9 à 13, dans lequel l'application d'une pluralité de semi-conducteurs (126) comprend l'application d'un mélange de la pluralité de semi-conducteurs (126) et d'un milieu non conducteur.

15. Procédé selon l'une quelconque des revendications 9 à 14, comprenant en outre les étapes consistant à :
appliquer une première couche d'un adhésif conducteur (330) sur la première plaque de montage (106) ;
appliquer une seconde couche de l'adhésif conducteur (330) sur la seconde plaque de montage (108) ; et
appliquer une couche de matériau résistif entre les première et seconde couches d'adhésif conducteur (330).
